# EUROPEAN PATENT SPECIFICATION

(11) **EP 3 379 655 B1**
(45) Date of publication and mention of the grant of the patent: **08.03.2023**
(21) Application number: 18163421.3
(22) Date of filing: 22.03.2018
(51) Int. Cl.: H01R 13/05, H01R 13/53, H01R 24/66

(54) **ELECTRICAL CONNECTOR AND ELECTRICAL CONNECTION ARRANGEMENT COMPRISING AN ELECTRICAL CONNECTOR**
ELEKTRISCHER VERBINDER UND ELEKTRISCHE VERBINDUNGSANORDNUNG MIT EINEM ELEKTRISCHEN VERBINDER
CONNECTEUR ÉLECTRIQUE ET AGENCEMENT DE CONNEXION ÉLECTRIQUE COMPRENANT UN CONNECTEUR ÉLECTRIQUE

(30) Priority: 23.03.2017 DE 102017204939
(43) Date of publication of application: 26.09.2018
(73) Proprietor: TE Connectivity Germany GmbH, 64625 Bensheim (DE)
(72) Inventor: Eckel, Markus, 68642 Bürstadt (DE)
(74) Representative: Grünecker Patent- und Rechtsanwälte PartG mbB

(56) References cited:
- WO-A1-2015/098512
- WO-A1-2016/060123
- WO-A2-2006/068803
- DE-A1- 3 245 072
- DE-A1-102012 216 694
- DE-A1-102015 016 267
- DE-B3-102007 055 235
- US-A1- 2011 143 580
- US-A1- 2015 078 042

## Description

The invention relates to an electrical connector with at least one electrical contact element which is received in a housing. The invention further relates to an electrical connection arrangement with such an electrical connector.

Electrical connectors are used, for example, in vehicles, in particular electrically operated vehicles, for example for transmitting electrical power. Larger connectors have hitherto been used for transmitting larger powers. However, this is not very desirable due to the limited space available.

In order to provide a solution with which a larger power can be transferred with a connector of an unvarying size or an unvarying power can be transferred with a connector of a smaller size, the electrical connector can comprise a heat bridge, which has a heat absorption surface which is thermally connected to the electrical contact element and a heat transfer surface which is accessible from outside the connector and electrically insulated from the contact element.

DE 10 2015 016267 A1 shows a device for cooling an electroconductive contact element of a plug-in connection, the contact element being surrounded by a pin trough wherein the device comprises a heat conducting element which is coupled to the electroconductive contact element and via which waste heat can be dissipated from the contact element out of the pin trough. DE 10 2007 055235 B3 discloses an electrical connector according to the preamble of claim 1, specifically an electrical plug-in contact of an electric machine of an electric drive system for a motor vehicle, particularly a hybrid vehicle, wherein the electrical plug-in contact comprises a plug-in housing with a connection element that can be contacted from outside and is connected in an electrically conducting manner to a terminal of the electric machine and wherein the plug-in housing at least partly surrounds an electrical connecting lead between the connection element and the machine terminal such that a heat sink is formed. In US 2011/143580 A1 a socket terminal heat-dissipating mechanism is provided for use in an electronic device, wherein the electronic device includes a frame and a casing and the socket terminal heat-dissipating mechanism includes a socket and an insulating layer. DE 10 2012 216694 A1 shows a contact bush having a bush main unit that is provided with an electrically conductive housing, a main electrical conduit and an electrically insulating heat-conducting element, wherein the electrically conductive housing is designed to receive a connector pin and the main electrical conduit is electrically connected to the electrically conductive housing. WO 2016/060123 A1 shows a service plug that can be inserted into a load circuit, wherein heat can be dissipated by a heat pipe.

In order to provide a more secure electrical connector, the heat bridge is connected to the electrical contact element via a welding connection.

It is an object of the invention to allow a particularly compact arrangement of the electrical contact element and the heat sink.

According to the invention, this object is achieved by an electrical connector according to claim 1, specifically when the heat absorption surface and heat transfer surface are arranged L-shaped with respect to one another in a cross-section of the heat bridge, wherein the heat bridge has an electrically insulating layer on the heat absorption surface and/or on the heat transfer surface, and wherein an abrasion protection is arranged between the electrically insulating layer and the housing.

A connection arrangement according to the invention is disclosed by claim 6 and comprises an electrical connector according to the invention.

The heat absorption surface and heat transfer surface are arranged L-shaped with respect to one another in a cross-section of the heat bridge. Thus, heat which is generated by the power transmission in the contact element can be dissipated. As a result, more power can be sent through the contact element or smaller contact elements and thus smaller connectors can be used to transmit a given power. The electrical insulation ensures that the contact elements are not electrically connected to further elements, in particular a heat sink. Due to the electrically insulating layer, the solution can be easily used with existing connectors, for instance by adding a heat bridge. The abrasion protection serves to protect the electrically insulating layer upon introduction into the housing, in particular from damage by friction. The abrasion protection can on one side be at least partially complementary to the element on which the electrically insulating layer is arranged, i.e. in particular complementary to the heat bridge. On the other side, the abrasion protection can be at least partially complementary to a part of the housing on which it rests in the fitted state.

The solution according to the invention can be further improved with the following configurations and further developments which are each advantageous per se.

If the heat bridge has an electrically insulating layer on the heat absorption surface, i.e. if an electrically insulating layer is arranged at the contact element side, a further insulation on the heat transfer surface can thus be dispensed with.

If the electrically insulating layer is arranged on the heat transfer surface, i.e. arranged at the heat sink side, an insulation can, in turn, be dispensed with in the region of the heat absorption surface.

In a particularly advantageous configuration, an electrically insulating layer is present on the heat absorption surface and also on the heat transfer surface, in order to achieve a particularly good electrical insulation. For example, a single electrically insulating layer can extend completely or almost completely over the surface of the heat bridge.

A particularly easy-to-attach electrically insulating layer can, for example, be a foil, in particular a heat transfer surface which has a particularly good heat transfer coefficient and at the same time ensures an electrical insulation.

In a further configuration, an electrically insulating layer can be attained, for example, by a coating. The heat bridge can be coated, for instance, by spraying or in a dipping process. An at least partial injection moulding with electrically insulating material in a moulding method, for instance, is also possible.

Additionally to the electrically insulating layer, other electrically insulating elements can also be used. For example, insulating elements made of thermally conductive rubber or thermopads, for instance, can be used for heat transfer.

Additionally to the arrangement on the heat bridge, an electrically insulating layer or an electrically insulating element can also be present at other locations. In particular, the electrical contact element can have an electrically insulating layer or an electrically insulating element, in order to enable a heat transfer at the same time as electrical insulation. An arrangement between the heat bridge and the heat sink is also possible. An electrically insulating layer or an electrically insulating element with a good heat transfer can, for example, be present on the heat sink.

The heat bridge can be formed at least partially complementary to a surface of the electrical contact element, in particular in the region of the heat absorption surface, in order to achieve a good thermal contact. Correspondingly, the heat transfer surface can be formed at least partially complementary to the heat sink.

In order to enable a good heat transfer, the heat absorption surface and/or the heat transfer surface can make up a large part of the surface of the heat bridge, for example at least 10%, preferably at least 20%, 30% or 40% of the surface respectively.

In order to ensure a good transfer, the thermal connection path between the heat absorption surface and the heat transfer surface should be as short as possible. The distance between the heat transfer surface and the heat absorption surface can, for example, be less than 50% of the length of the heat bridge, preferably 30%, 20%, 10% or less.

In order to enable a good heat transfer within the electrical contact element and to avoid an unnecessary heating of the electrical contact element, the heat absorption surface should be arranged as near as possible to a location at which the heat is generated in the electrical contact element or at which the heat is transferred to the electrical contact element. For example, heat can be generated at a point of connection of the contact element to a mating contact element. In order to then enable a good heat transfer, the heat absorption surface should be arranged near this point of connection. In particular, no further element can be arranged between the heat absorption surface, or the part of the heat bridge which comprises the heat absorption surface, and the point of connection, or only a small housing element which is necessary for the electrical insulation or for sealing. The distance between the point of connection and the heat absorption surface can be, for instance, less than 30%, preferably less than 20%, more preferably less than 10% of the length of the electrical contact element.

The heat bridge can be made from a material or comprise a material which possesses a good thermal conductivity, for instance copper. By virtue of the electrical insulation, the heat bridge can also consist of an electrically conductive material, for instance a metal. In order to reduce the manufacturing complexity, the heat bridge can comprise a material which is also used for the electrical contact element. The material can be particularly easy to shape and easily available. However, the heat bridge can also consist of a material which is electrically insulating but which also has good thermal conductivity.

A particularly compact arrangement of the electrical contact element and the heat sink is possible as the heat absorption surface and heat transfer surface are arranged L-shaped with respect to one another in a cross-section of the heat bridge. The heat bridge can comprise an L-shaped section for attaching the heat bridge to a surface of the heat sink which runs transversely thereto. The L-shape can have two limbs which form an angle therebetween. The angle can in particular be 90° such that mounting to a surface of the heat sink, which runs perpendicular to the electrical contact element, is possible.

In order to enable a particularly simple production, the heat bridge can comprise a separated part of an extruded profile. Such a heat bridge can be produced very economically. Further parts can be applied onto such a separated part, for example an electrically insulating layer in the form of a foil. However, such a foil can also be applied on the extruded profile, such that only a separation of a part of the extruded profile is necessary for producing the heat bridge. An extruded profile or a separated part of an extruded profile can have translational symmetry. In particular, a cross-section can thus remain the same in a longitudinal direction of the extruded profile or repeat a certain shape along an extension direction of the extruded profile. In particular, the heat bridge can be a separated part of an extruded profile without further additional elements.

In order to enable a simple assembly of the heat bridge, said heat bridge can be configured symmetrically. As a result, it is no longer necessary to consider the orientation of the heat bridge when it is assembled. In particular, the heat bridge can be rotationally symmetrical, i.e. the heat bridge is unchanged after a rotation about 180°.

In an advantageous configuration, the heat transfer surface can be an inner surface of a tube or a cylinder. The heat transfer surface or the heat bridge can be configured to receive a tube. Such a tube can, for instance, serve to conduct an actively pumped-through medium, as is the case, for instance, during water cooling, or to receive a medium which serves to transfer heat and flows through itself by virtue of physical laws, as is the case, for instance, in a heat pipe. The heat bridge can have receptacles for attaching a tube. The receptacles or the inner surface can be completely closed in a radial direction, for instance with a circular cross-section, or only partially closed such that a C-shaped cross-section, for instance, arises. In addition to a cylindrical configuration, other possibilities are also conceivable, for instance with a cross-section which is elliptical, rectangular, polygonal or arbitrarily shaped. The receptacles can penetrate the heat bridge, in order to enable an inflow and outflow.

In a further configuration, a continuous receptacle can itself serve as a channel for a coolant. Coupling elements, for example for attaching conduits for the coolant, can be provided at the start and at the end of such a receptacle. These can be clamping surfaces, clamping inserts or screw threads, for instance. Several receptacles from several heat bridges from various contact elements can be connected to one another, such that they can be cooled with a single cooling system. In order to enable as long an interaction as possible between the coolant and the heat transfer surface and thus increase the performance, a receptacle can run through the heat bridge in a shape which deviates from a straight shape. For example, the receptacle can run in a zigzag or meandering manner. Several receptacles which are connected to one another or can be connected to one another via an external element can also be present in order to achieve a high cooling performance. In order to achieve a heat transfer surface which is as large as possible with a receptacle which has a small volume, the receptacle can have a cavity, the measurement thereof being much smaller in one dimension than the measurements in the two other dimensions. Such a flat configuration of the receptacle can also be particularly space-saving.

If several electrical contact elements are present, they can be connected with a single heat bridge in order to keep the construction simple. This is possible in particular if an electrical insulation between the contact elements and the heat bridge is present, or if the electrical contact elements are all at the same potential.

In order to enable an even more efficient cooling, the heat bridge can have at least one additional heat transfer surface. Such an additional heat transfer surface can in particular also be used for a passive cooling, for example by air. Cooling fins can, for instance, be present on the heat bridge, which cooling fins are configured to cool in the air. Such cooling fins can be integral with the heat bridge and the additional heat transfer surface can be arranged at the cooling fins.

In an advantageous configuration, the electrical connector can have a pressing element via which a contact pressure between the electrical contact element, the heat bridge, a heat sink and/or the housing is produced in an assembled state. Such an element can, for example, be introduced after at least some of the other elements are already assembled, in order to then achieve a high contact pressure on the heat absorption surface and/or the heat transfer surface and thus a good thermal connection. In particular, such a pressing element can be configured wedge-shaped and/or have a wedge-shaped cross-section. In order to avoid damaging an electrically insulating layer, the pressing element can be arranged at a distance from an electrically insulating layer. The electrical contact element can thus be arranged between the pressing element and the heat bridge for instance, or the pressing element can be arranged at a side of the heat bridge which is opposite the heat transfer surface or the heat absorption surface.

In order to produce a contact pressure based on material properties, the pressing element can in particular be at least partially elastic.

In an advantageous configuration, the contact element has a rectangular cross section. The heat absorption surfaces can then be arranged on a longer side of the rectangular cross-section, in order to achieve a large surface and thus a good heat transfer. Other cross-sectional shapes of contact elements are naturally also possible, for example square or round cross-sections. In the case of a round cross-section, the heat absorption surface can be configured correspondingly complementarily in order to achieve a good heat transfer. A configuration in which the contact element only has a planar side at the location at which the receiving surface is in abutment and otherwise has a round cross-section is also possible.

The heat bridge can also have various configurations. For example, it can also have a rectangular cross-section in order to achieve a good heat transfer. Other possible cross-section shapes comprise, for example, a cross-section which is triangular, square or differently shaped. Furthermore, a 3D contour can also be present.

The electrical connector can be made up of one part or two parts. For example, the housing can comprise one part or two parts. In the case of a one part configuration, it is possible, for example, to attach the connector from one side to a further element. In the case of a two-part configuration, a further element can be clamped between the first part and the second part and, as a result, a good mounting is achieved.

An electrical connection arrangement according to the invention comprises an electrical connector according to the invention. Furthermore, the electrical connection arrangement can also comprise a heat sink which is attached to the electrical connector.

In an advantageous configuration, the heat bridge is connected to the heat sink in an electrically insulating manner. An electrically insulating layer can, for example, here too be present on the heat bridge, but also on the heat sink. Furthermore, further electrical insulating elements can be present which however enable a good thermal transfer. In particular, an electrically insulating element or an electrically insulating layer can also only be present on the heat sink, but not on the heat bridge or on the contact element.

The heat sink can in particular, for example, be a unit housing of an electrical unit, for instance in a vehicle. The unit housing can be made from a material which has good thermal conductivity, such as metal. The unit housing can, for example, then serve as a passive cooling element which absorbs the heat which is generated in the connector and, for example, emits it to the surrounding environment.

The electrical connector can be configured for mounting on a unit housing. It can thus have connecting elements such as screws which cooperate with corresponding mating elements on the unit housing. The electrical connector can be configured in particular to press the heat transfer surface against the heat sink in the event of an attachment to the unit housing or the heat sink, in order to produce a particularly good thermal contact.

In order to enable a particularly compact configuration, the electrical connector can penetrate the unit housing surface in the assembled state.

In an advantageous configuration, the unit housing can have a heat contact tongue which projects into a recess for the plug and which is in direct thermal contact with the heat bridge in the assembled state of the connector. As a result, a heat transfer is particularly efficient.

In a particularly space-saving configuration, the contact tongue can project into the recess perpendicular to a longitudinal direction of the electrical contact elements.

Hereinafter, the invention is explained in greater detail by way of example using advantageous configurations with reference to the drawings. The advantageous further developments and configurations depicted here are each independent of one another and can be freely combined with one another, depending on how this is necessary in the application.

In the drawings:
- Fig. 1: shows a schematic perspective view of a first embodiment;
- Fig. 2: shows a schematic sectional view of the first embodiment;
- Fig. 3: shows a schematic perspective view of the first embodiment from below;
- Figs. 4A, 4B: show various schematic perspective views of the heat bridge of the first embodiment;
- Fig. 5: shows a schematic perspective view of the heat sink of the first embodiment;
- Fig. 6: shows a schematic perspective view of various elements of the first embodiment;
- Fig. 7: shows a schematic sectional view of a second embodiment;
- Fig. 8: shows a schematic perspective view of various elements of the second embodiment;
- Fig. 9: shows a schematic perspective view of the second embodiment from below;
- Fig. 10: shows a schematic sectional view through a third embodiment;
- Fig. 11: shows a schematic perspective view of elements of the third embodiment;
- Fig. 12: shows a schematic perspective view of the third embodiment from below;
- Fig. 13: shows a schematic sectional view of a fourth embodiment;
- Figs. 14A, 14B: show schematic perspective views of elements of the fourth embodiment;
- Fig. 15: shows a schematic perspective view of the fourth embodiment from below;
- Fig. 16: shows a schematic sectional depiction of a fifth embodiment;
- Figs. 17A, 17B: show schematic perspective views of the fifth embodiment;
- Fig. 18: shows a schematic sectional view of a sixth embodiment;
- Figs. 19A, 19B: show schematic perspective views of various elements of the sixth embodiment;
- Fig. 20: shows a schematic sectional view of a seventh embodiment;
- Figs. 21A, 21B: shows schematic perspective views of various elements of the seventh embodiment;
- Figs. 22, 23, 24: show schematic perspective views of an eighth embodiment;
- Fig. 25: shows a schematic sectional view of the eighth embodiment;
- Fig. 26: shows a schematic sectional view of a ninth embodiment;
- Fig. 27: shows a schematic sectional view of a tenth embodiment;
- Fig. 28: shows a schematic sectional view of an eleventh embodiment;
- Fig. 29: shows a schematic sectional view of a twelfth embodiment;
- Fig. 30: shows a schematic sectional view of a thirteenth embodiment;
- Fig. 31: shows a schematic sectional view of a fourteenth embodiment;
- Figs. 32A, 32B: show schematic perspective views of parts of the fourteenth embodiment.

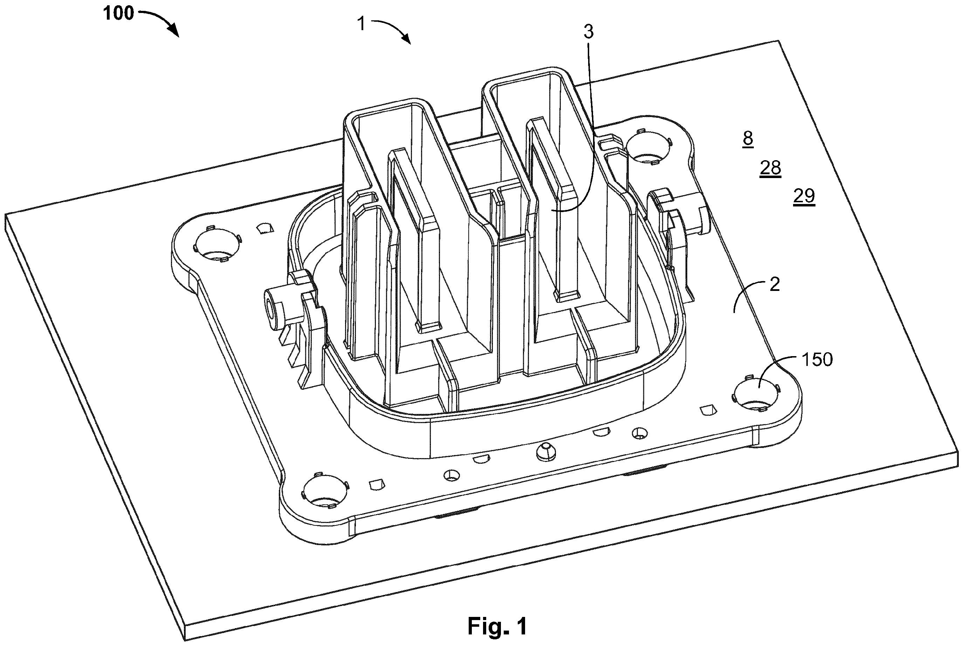

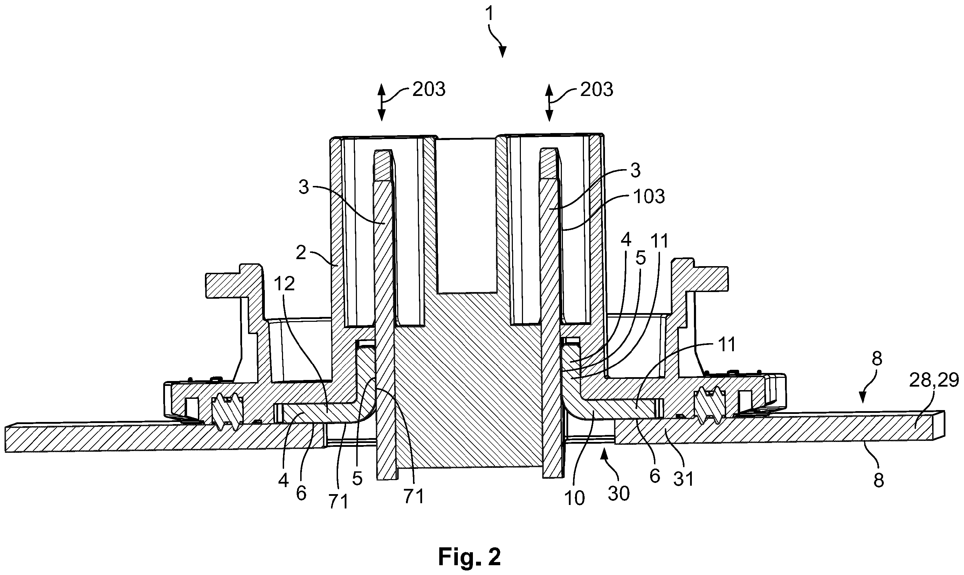

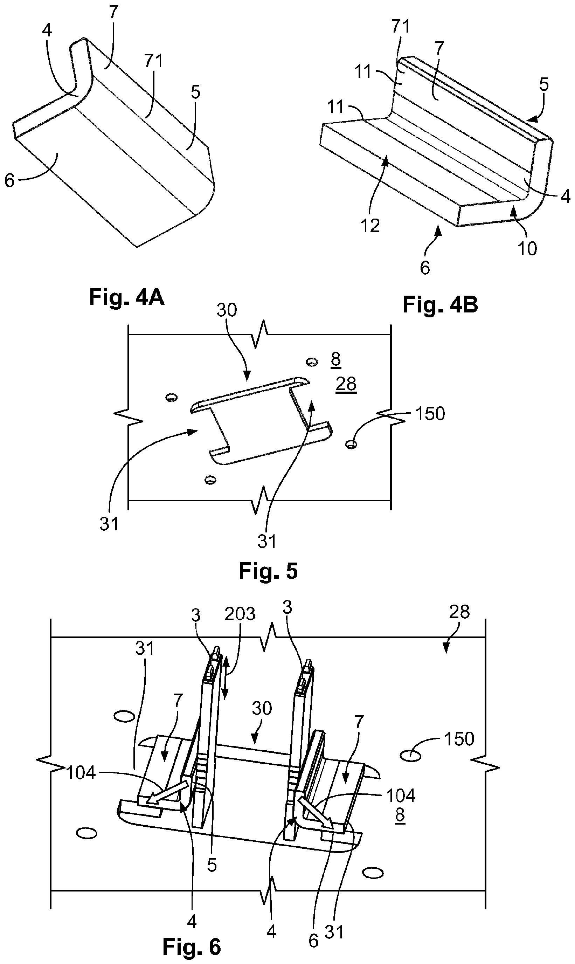

In Figures 1 to 3, various views of a first embodiment are shown. In Figures 4A, 4B, 5 and 6, some parts of the first embodiment from Figures 1 to 3 are depicted in detail.

An electrical connector 1 is attached to a unit housing 28, for example of an electrical unit of a vehicle. Currents are to be transmitted into the interior of the unit housing 28 or out of the unit housing 28 via the connector 1. For this purpose, the connector 1 possesses electrical contact elements 3 to which corresponding mating elements of a mating plug (not shown) are attached. In the case of such a transmission of electrical power, firstly the electrical contact elements 3 heat up by virtue of the internal resistance. Secondly, heating occurs in the region of points of connection 103, at which points of connection the contact elements 3 are in contact with the mating elements. The maximum heat permitted thus represents the limit for the power transmission.

In order to cool a contact element 3 or to dissipate the heat present therein, the connector 1 possesses a heat bridge 4. The heat bridge 4 is connected to the contact element 3 at a heat absorption surface 5. The heat bridge 4 lies planarly on the contact element 3 at the heat absorption surface 5, in order to be able to transfer as great an amount of heat as possible as quickly as possible. The received heat is then emitted in the region of a heat transfer surface 6 to a heat sink 8 which in this case is the unit housing 28. In turn, the unit housing 28 emits the heat to the environment. A passive cooling thus arises here, without movable parts and without further assistance.

In order not to produce an electrical connection between the contact element 3 and the heat sink 8, the heat transfer surface 6 is electrically insulated from the contact element 3.

As can be seen in particular in Figures 4A, 4B and 6, the heat bridge 4 possesses an electrically insulating layer 7 for this purpose in the form of a foil 71 which has good thermal conductivity, but which is simultaneously electrically insulating.

In the first exemplary embodiment shown, the electrically insulating layer 7 is almost completely arranged on an outer side of the heat bridge 4. In particular, the electrically insulating layer 7 is also arranged in the region of the heat absorption surface 5 and in the region of the heat transfer surface 6. Double protection against an electrical contact is thus achieved, namely in the region of the heat transfer surface 6 and in the region of the heat absorption surface 5.

If the connector 1 is not attached to the unit housing 28, then the heat transfer surface 6 is accessible from the outside.

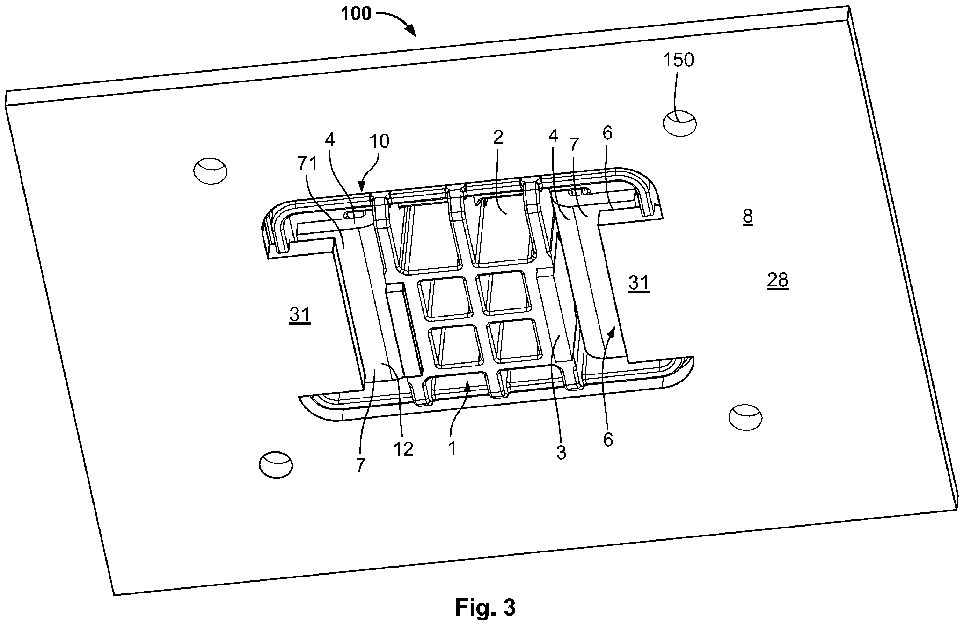

It can be seen in particular in Figures 3 and 5 that the unit housing 28 has heat contact tongues 31 which protrude into a receptacle 30 for the connector 1, in order to enable a coupling of the heat bridge 4 to the heat sink 8 in the form of the unit housing 28.

In Fig. 6, the heat flow 104, which goes out of the contact elements 3 via the heat bridges 4 into the heat sink 8, is schematically indicated.

The heat bridge 4 has an L-shape 10. The heat absorption surface 5 runs perpendicular to the heat transfer surface 6, the surfaces each being arranged at one of two limbs 11. By virtue of such a perpendicular configuration, the heat absorption surface 5 and the heat transfer surface 6 can each be connected planarly to the contact element 3 and the heat sink 8 respectively, a compact configuration being simultaneously possible.

The heat bridge 4 is a part 12 of an extruded profile and can have been produced, for example, by simple separation. The foil 71 can already be present on the extruded profile or only be added later after the separation.

In the embodiments shown, a foil 71 is in each case used as an electrically insulating layer 7. However, other configurations of an electrically insulating layer 7 are also possible. For example, an electrically insulating layer 7 can be produced by coating, spraying, immersion or similar methods. Other elements can also be used as an electrically insulating layer 7 to ensure the electrical insulation, for example thin and/or planar heat-conducting elements.

By attaching screws 151 in holes 150, the connector 1 can be pressed onto the unit housing 28, whereby a good thermal contact between the heat transfer surface 6 and the contact tongue 31 is possible.

The contact tongues 31 each project perpendicular to a longitudinal direction 203 of the electrical contact elements 3 into the recess 30 and therefore allow a compact configuration.

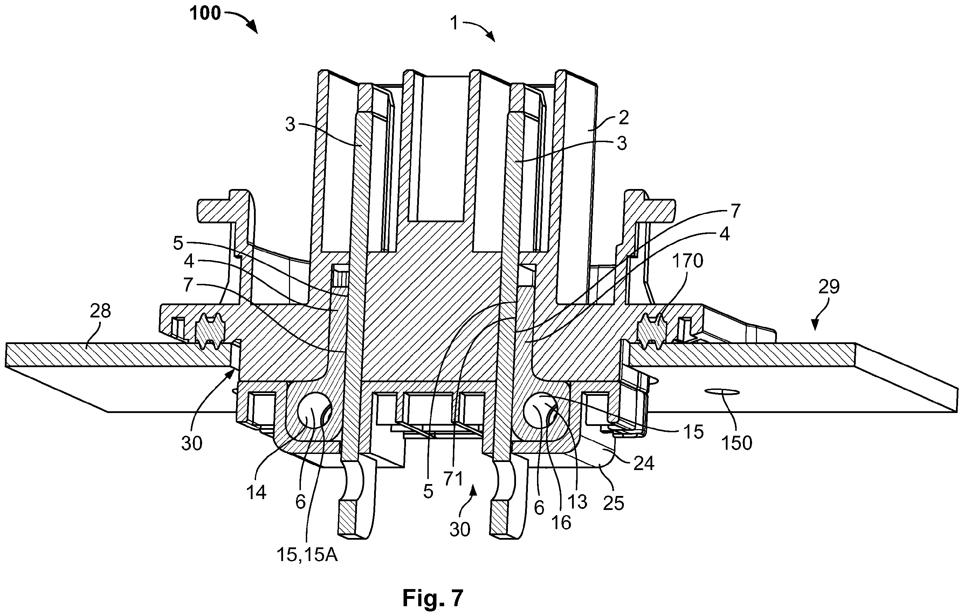

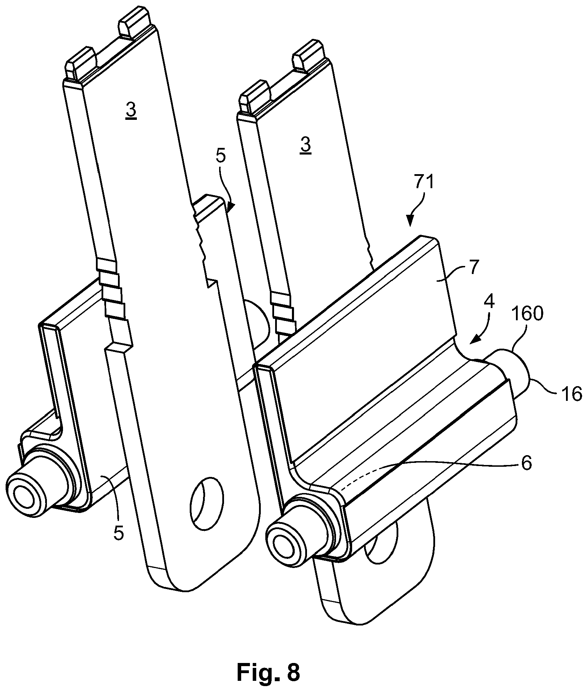

In Figures 7 to 9, a second embodiment is depicted. The connector 1 again comprises contact elements 3 which are thermally bonded to heat bridges 4 via heat absorption surfaces 5. The heat bridges 4 again serve to receive the heat which is present in the contact elements 3 and to pass on the heat via heat transfer surfaces 6 which in this case are formed as inner surfaces 13 of a cylinder or tube 14. The thus-transferred heat can, for example, then be dissipated with a water cooler 16 or by means of a heat pipe 17. Here, in each case, a medium flows along a circuit and takes the heat with it.

The heat transfer surfaces 6 are either the inner surfaces of a channel for the medium flowing through, or serve as receptacles 15, for example for a tube of a water cooler. In the second embodiment shown, a water cooler 16 is present which has terminal elements 160 which are attached to the ends of the cylindrical receptacles 15A and serve for coupling to the cooling system.

In order to ensure an electrical insulation, each of the heat bridges 4 again possess an electrically insulating layer 7 which electrically insulates the heat bridge 4 from the contact element 3, in particular in the region of the heat absorption surface 5.

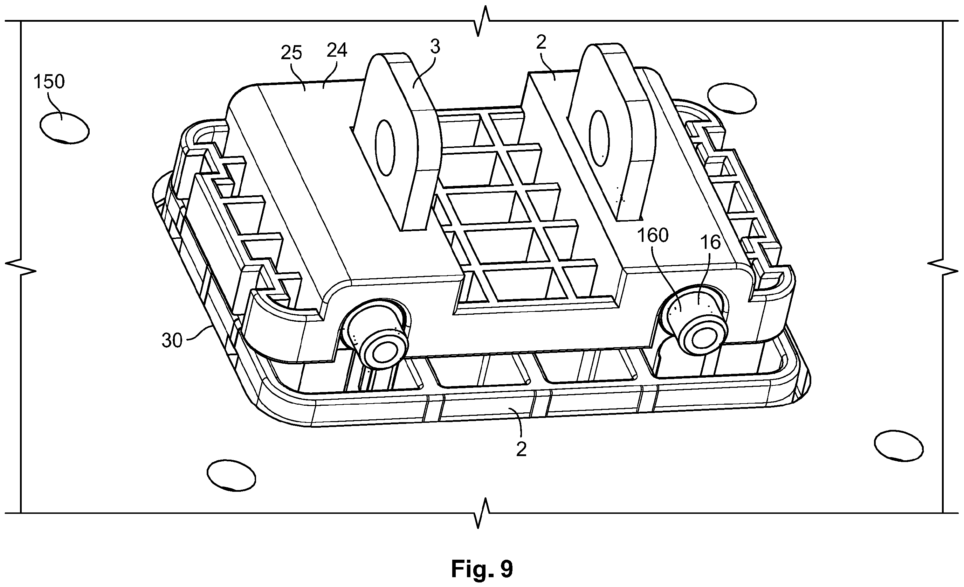

In Fig. 9, a further housing part 24 is shown which serves as a holding element 25 for the heat bridges 4 and the terminal elements 160.

As is the case in the other embodiments, the heat bridge 4 can again be part 12 of an extruded profile, in order to allow simple production.

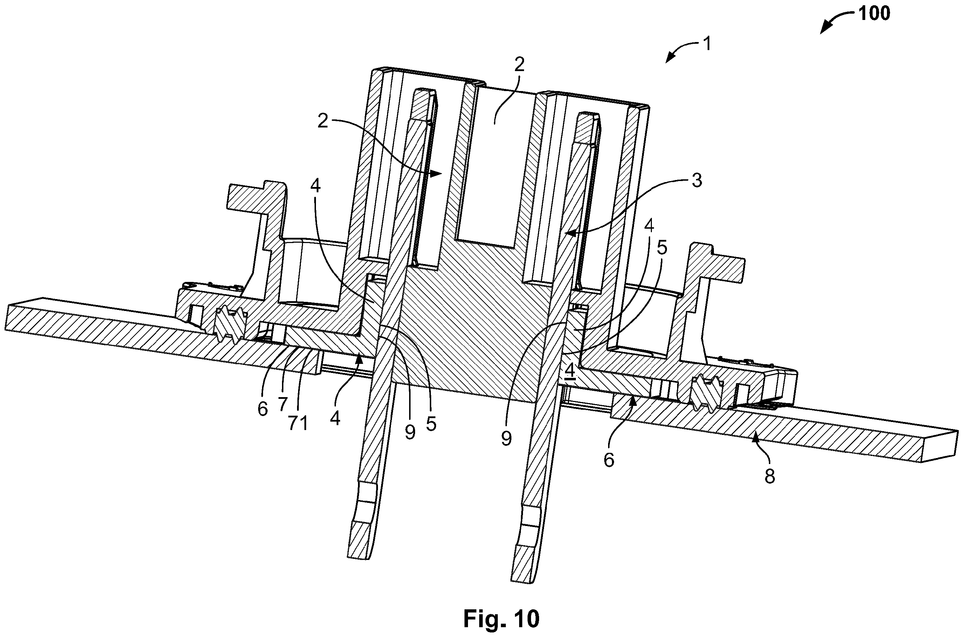

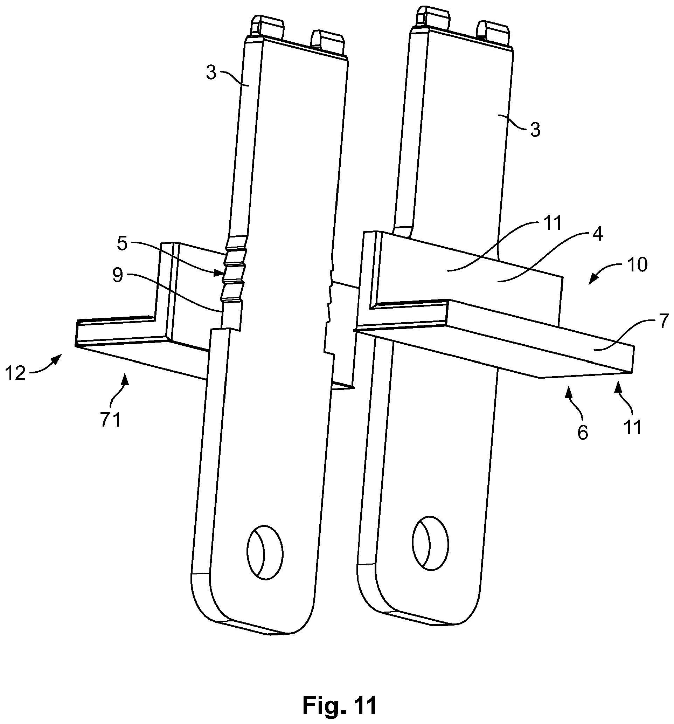

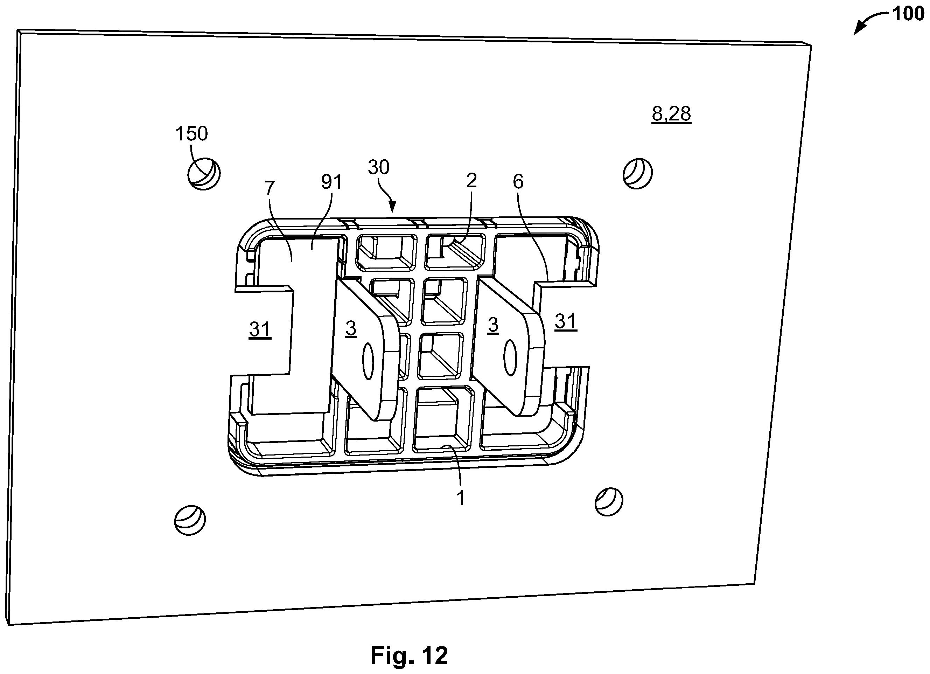

In Figures 10 to 12, a third embodiment is depicted. Heat bridges 4 with an L-shape 10 are again also present here. However, in contrast to the first embodiment, the heat bridges 4 are connected to the contact elements 3 via welding connections 9, in order to ensure a high degree of stability and a good heat transfer. Since a good electrical connection is present in the region of the heat absorption surface 5, the necessary electrical insulation is in this case attained in that an electrically insulating layer 7 is present in the region of the heat transfer surface 6.

In order to again improve the transfer to the heat sink 8 in the form of the unit housing 28, contact tongues 31 project into the receptacle 30. Such contact tongues 31 are not necessary in the second embodiment.

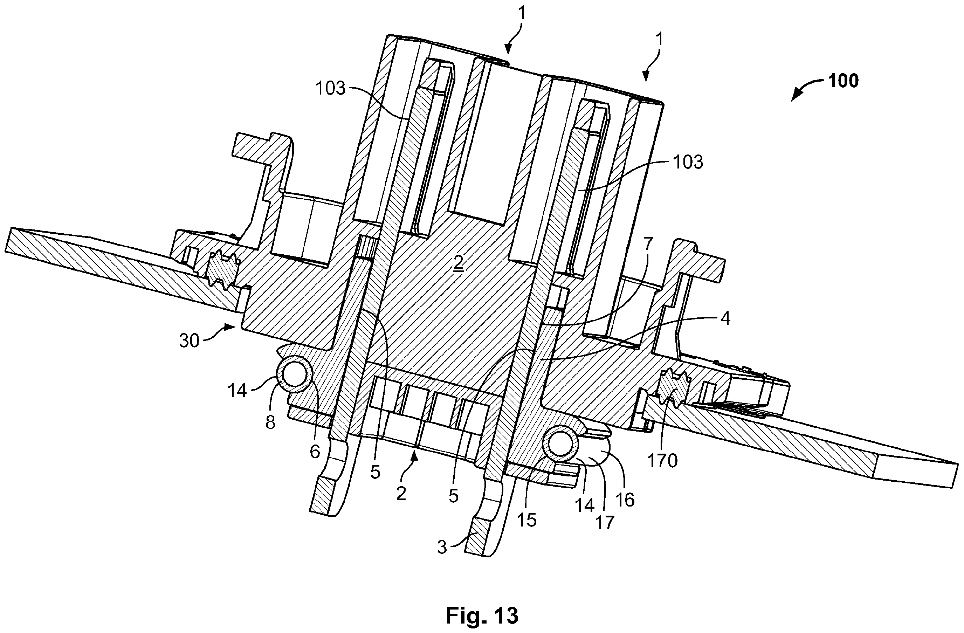

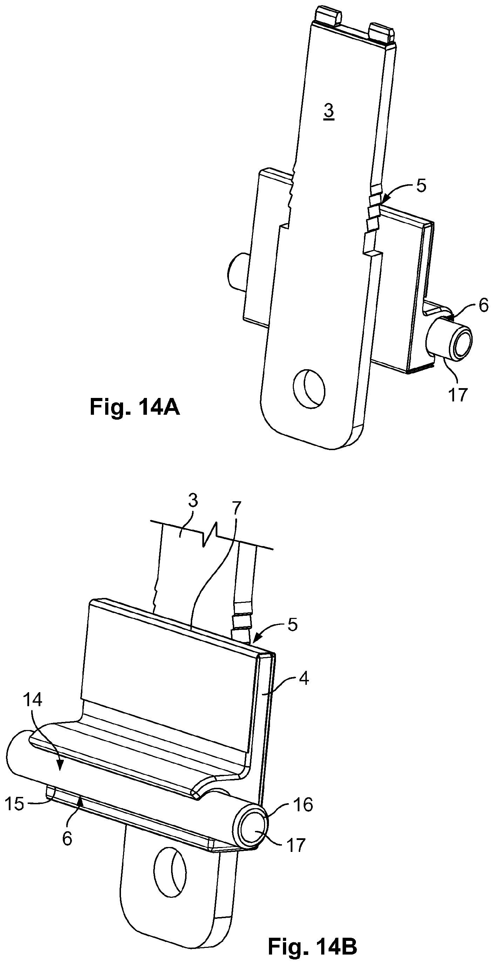

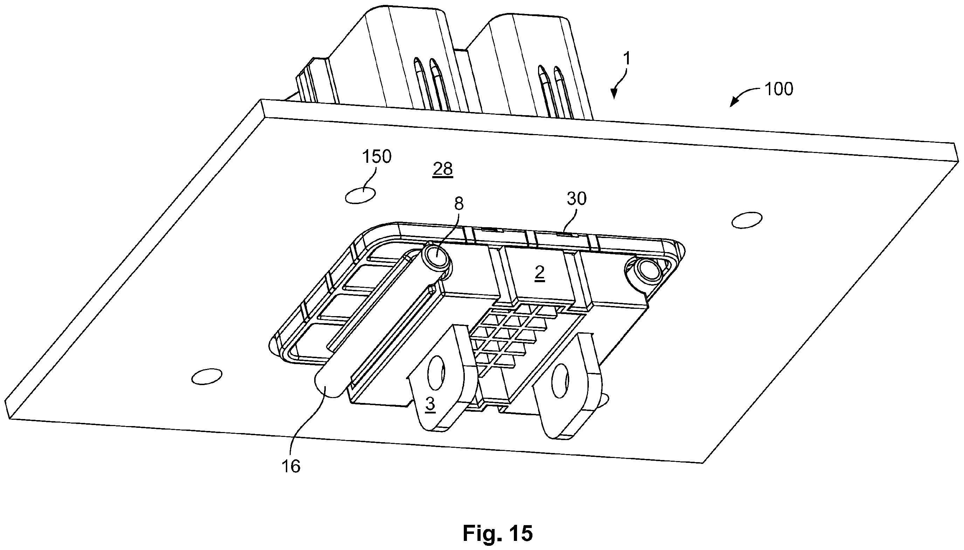

Figures 13 to 15 show a fourth embodiment. This fourth embodiment is similar to the second embodiment. Here too, the generated heat can be dissipated by active cooling, for example by a water cooler 16 or by a heat pipe 17. For this purpose, each heat bridge 4 possesses partially cylindrical receptacles 15 to which a corresponding tube 14 can be attached. The heat transfer surfaces 6 are in direct contact with such a tube 14, such that it can be considered to be a heat sink 8.

The necessary electrical insulation is again created by a foil 71 which is primarily arranged in the region of the heat absorption surface 5, but also arranged in order to prevent an electrical flashover along an air or creepage distance.

The receptacle 15 is, for instance, C-shaped or U-shaped and is open to one side, such that if there is a corresponding elasticity, the tube 14 can be laterally removed or introduced.

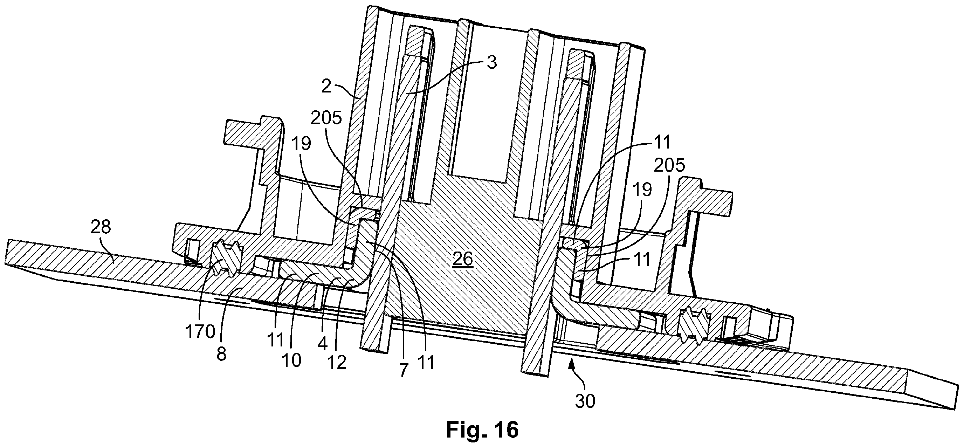

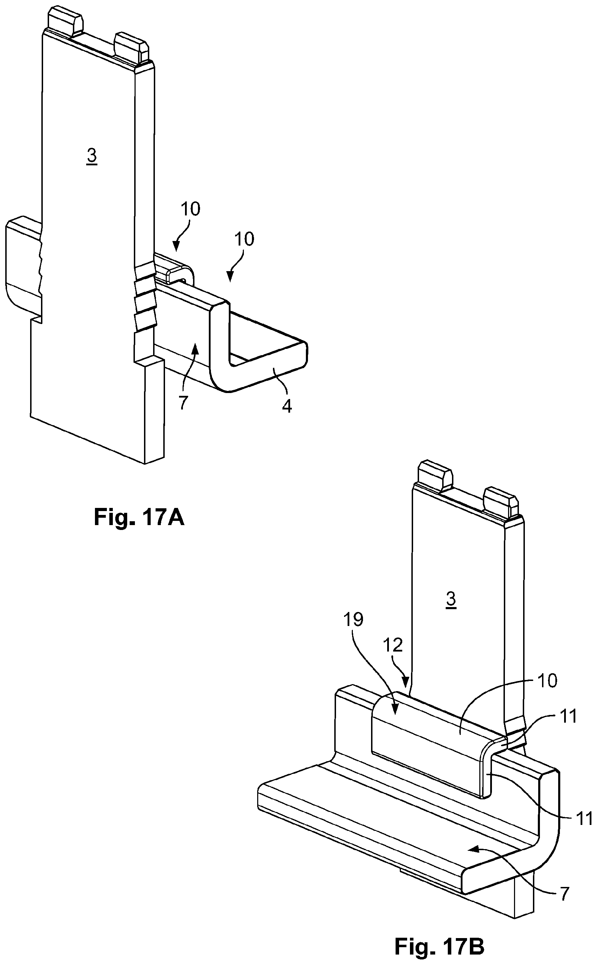

In a fifth embodiment which is shown in Figures 16, 17A and 17B, an abrasion protection 19 is present between the electrically insulating layer 7 on the heat bridge 4 and the housing 2. This serves to protect the electrically insulating layer 7 from a mechanical abrasion by the housing inner side upon introduction into the housing 2. The abrasion protection 19 is applied to the heat bridge 4 (see Fig. 17B), before both, together with the contact element 3, are introduced into the housing 2. The abrasion protection 19 is for this purpose complementary to the heat bridge 4 on one side, in particular a limb 11 of the heat bridge 4, and complementary to a receptacle 205 of the housing 2 on the other side.

The abrasion protection 19 has an L-shape 10 with two limbs 11 and can in particular be part 12 of an extruded profile, in order to attain simple producibility. It can, for example, be produced from an electrically insulating material or can be prevented from contacting voltage-carrying components through an appropriate formation.

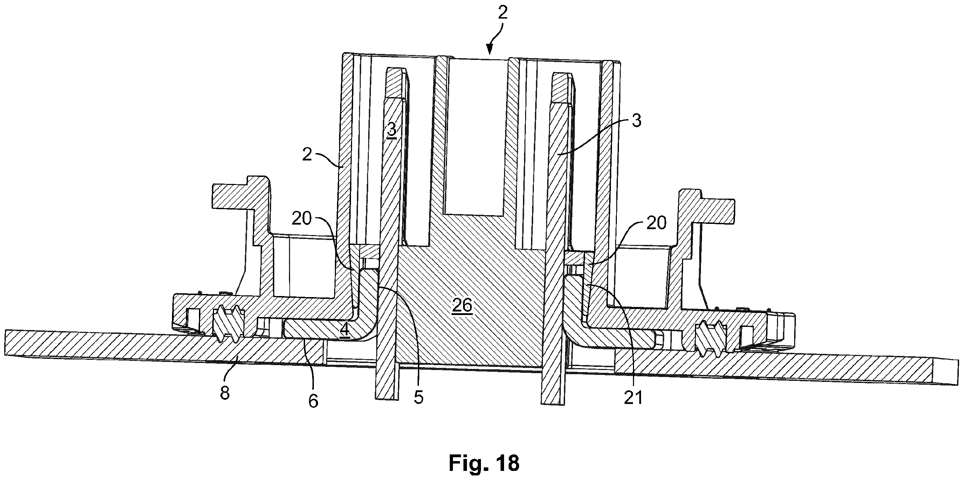

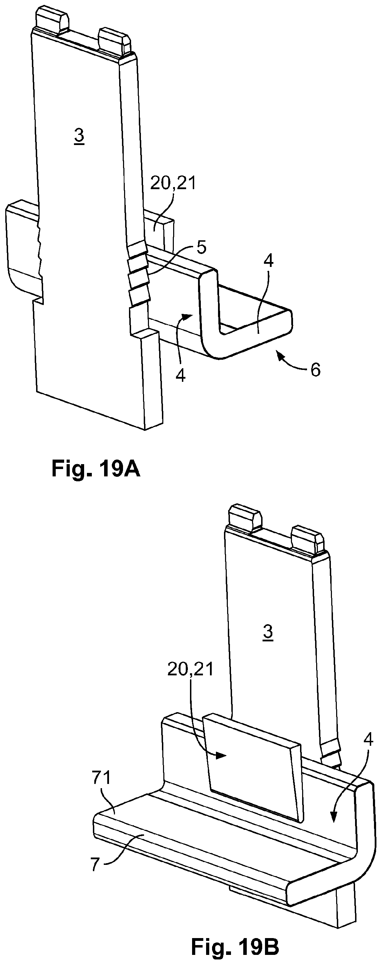

Figures 18 and 19 show an embodiment in which a pressing element 20 is present between the housing 2 and the heat bridge 4. In the assembled state, the wedge-shaped pressing element 20, 21 generates a contact pressure between the heat bridge 4 and the contact element 3, in particular in the region of the heat absorption surface 5. The contact element 3 is supported on the other side on a base 26 of the housing 2. The thermal transfer between the contact element 3 and the heat bridge 4 can be improved by the high pressure.

As is already the case in the preceding configurations, a contact pressure between the heat bridge 4 and the heat sink 8 is attained in the region of the heat transfer surface 6 in that the connector 1 is screwed onto the heat sink 8.

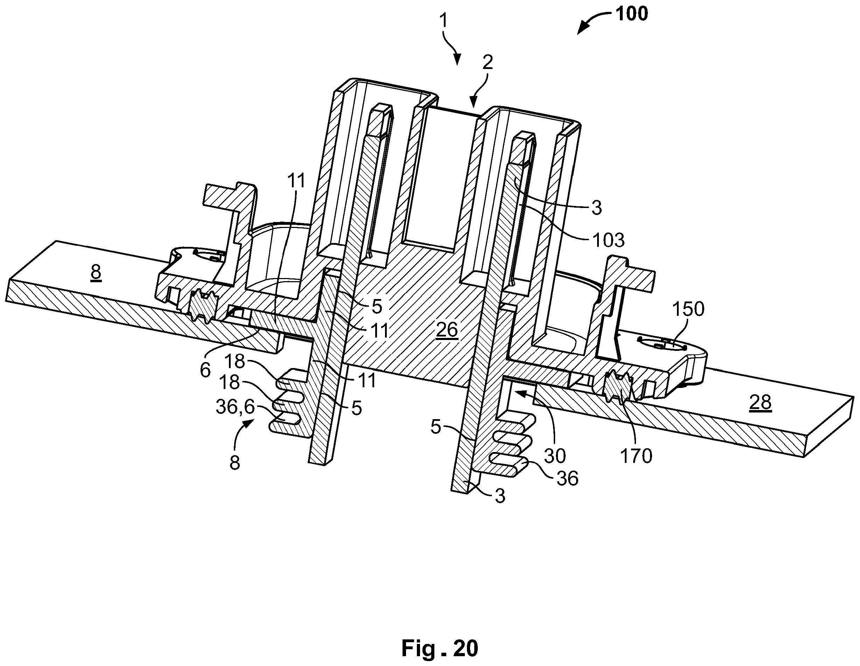

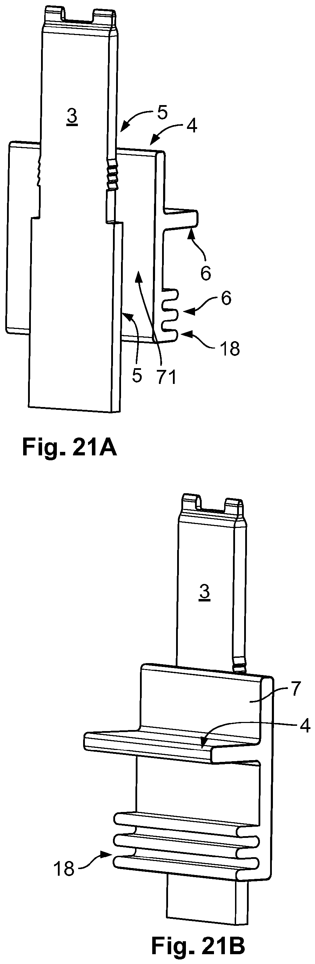

In a seventh embodiment which is shown in Figures 20, 21 and 21B, in addition to a first heat transfer surface 6, with which a connection to the heat sink 8 in the form of the unit housing 28 is produced, yet another heat transfer surface 6, 36 is present at the cooling fins 18. In this case, the environment, for example the air, serves as a heat sink 8, to which the additional heat transfer surface 6, 36 emits the heat. The cooling fins 18 supply a large surface in order to be able to transfer a correspondingly large amount of heat.

In the embodiments shown so far, the connector 1 was in each case made up of one part and could be inserted into the unit housing 28 from one side. In the following embodiments, the connector 1 is in each case made up of two parts, a first part 121 being arranged on a first side of the unit housing 28, for example an outer side, and a second part 122 being arranged on a second side of the unit housing 28, for example an inner side. Both of them can, for instance, be pressed together by screws 151 and thus cooperating mating elements 152 with internal threads, wherein they at least partially press the unit housing 28 therebetween.

The exemplary embodiments depicted hereinafter are similar to the exemplary embodiments already shown, but are adapted to the two-part embodiment.

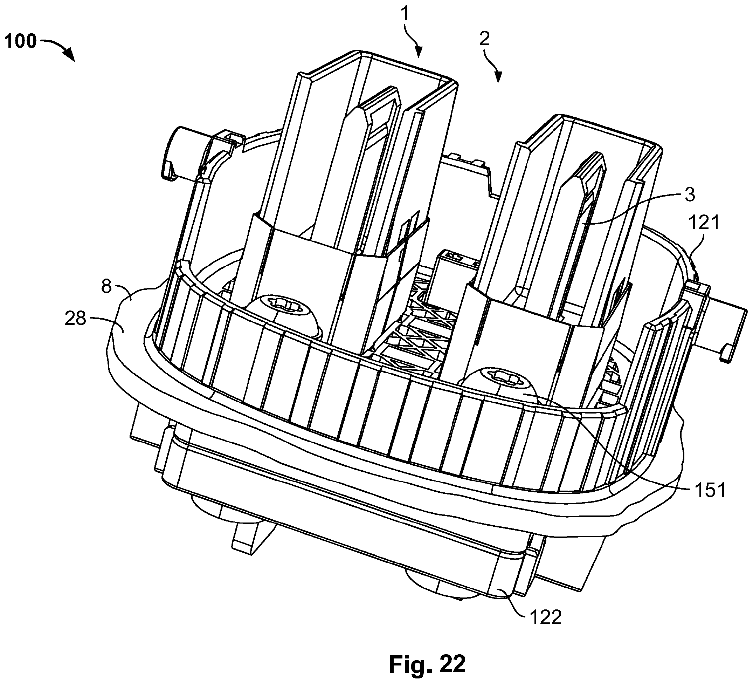

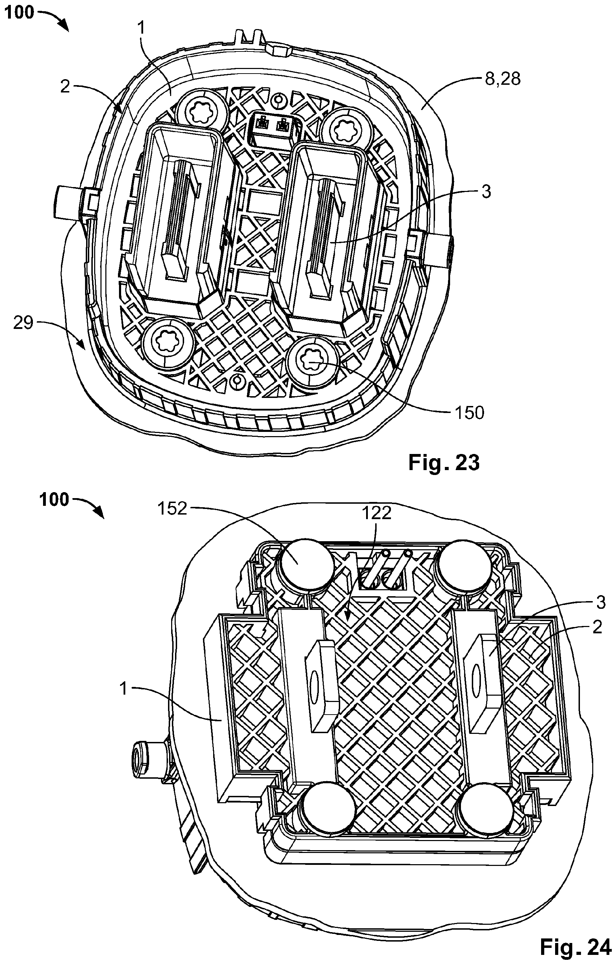

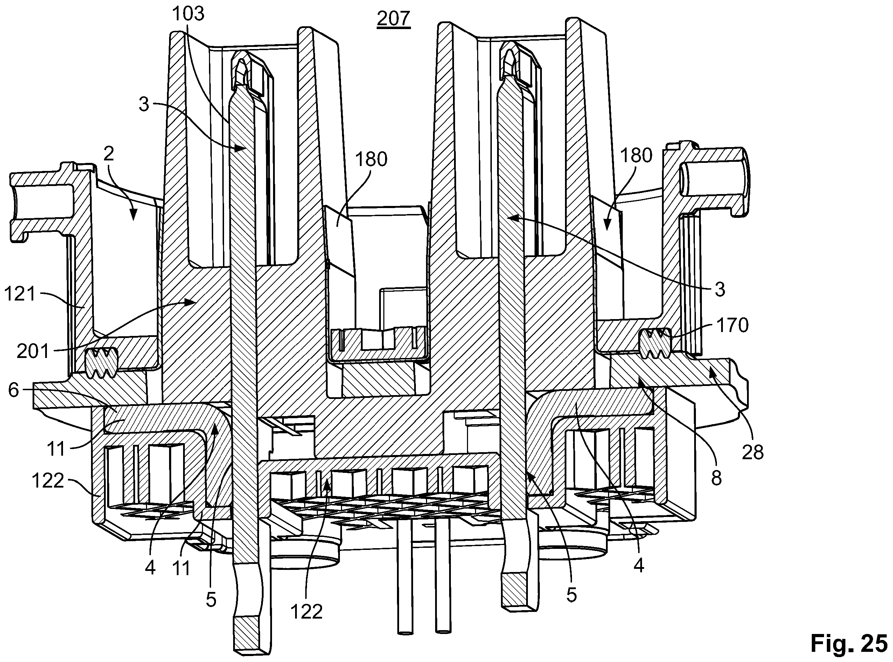

In Figures 22 to 24, the general structure of a two-part connector 1 is shown using an eighth embodiment (see also Fig. 25). This structure, with appropriate amendments, also applies to the following embodiments.

In Fig. 25, an eighth embodiment is depicted, in which an electrically insulating layer 7 is again present both in the region of a heat absorption surface 5 and also in the region of the heat transfer surface 6 on the heat bridge 4. A double insulation is thus possible. In contrast to the one-part configuration, a second limb 11 of the L-shaped heat bridges 4 here faces away from a plug-in side 207 on which the plug 1 is plugged together with a mating plug.

A shielding 180 is also shown, with which an electromagnetic shielding is achieved.

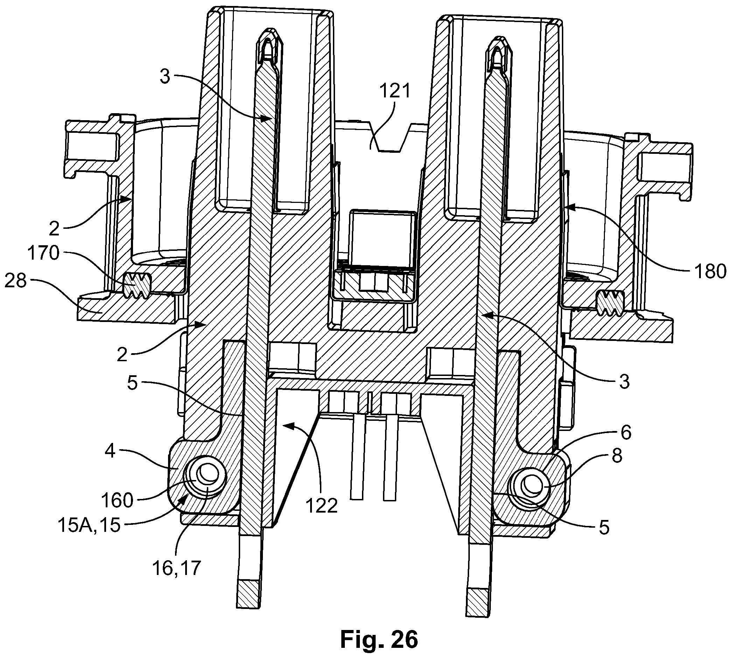

The ninth embodiment according to Fig. 26 corresponds to the second embodiment and can be used for using with a water cooler 16 or a heat pipe 17 for actively cooling and/or with a medium flowing through.

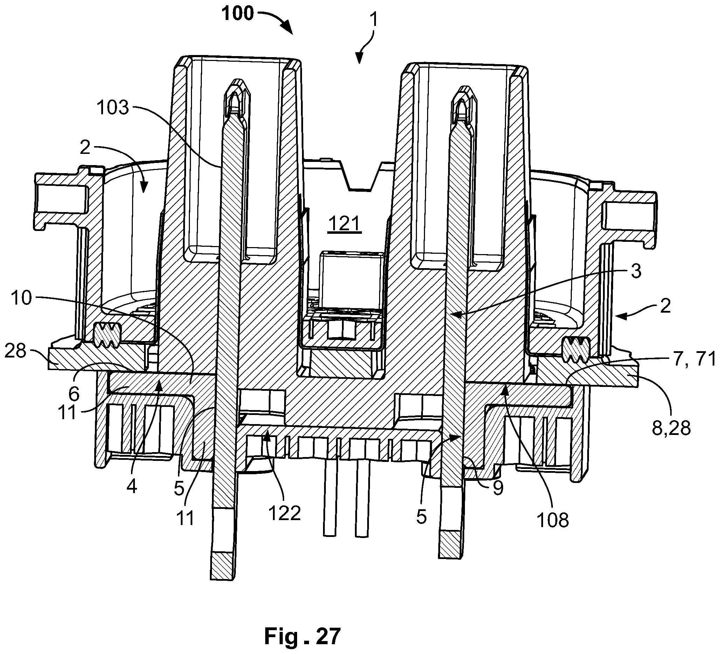

In the tenth embodiment which is shown in Fig. 27, a welding connection 9 is again present between the contact element 3 and the heat bridge 4. The necessary electrical insulation again takes place by a foil 71 which is arranged in the region of the heat transfer surface 6 on which the heat bridge 4 is attached to the heat sink 8 in the form of the unit housing 28.

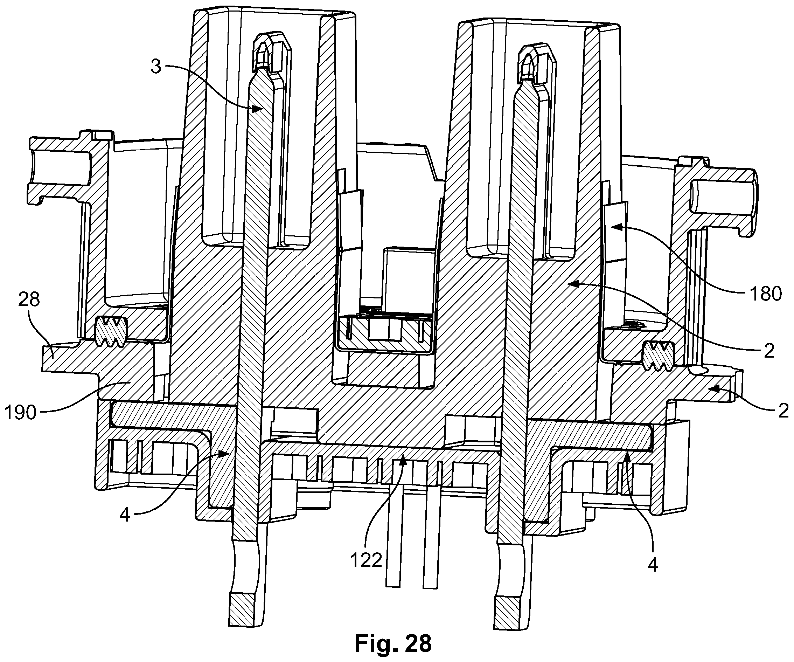

The eleventh embodiment according to Fig. 28 is similar to the tenth embodiment, but differs from it by an additional step 190 present on the unit housing 28 with which, for example, a spacing from the housing is possible, for instance in order to enable air cooling. In the tenth embodiment, an air circulation can be enabled, for instance by recesses (cut-outs) in the unit housing 28.

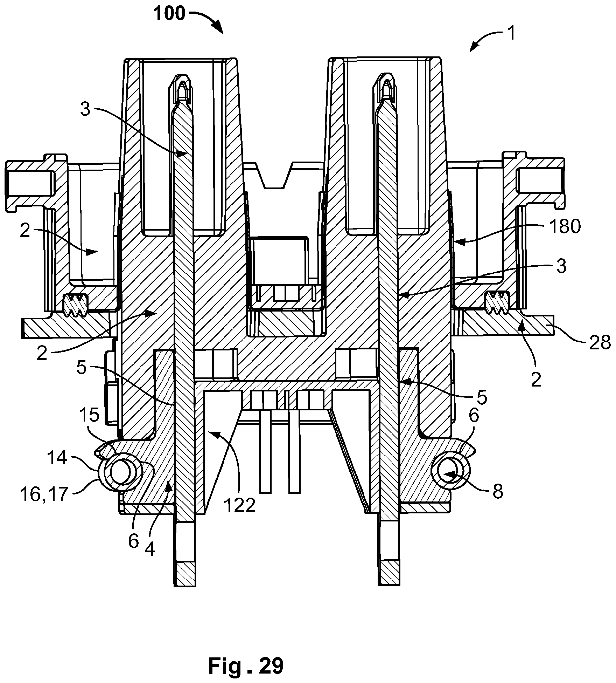

In the twelfth embodiment, see Fig. 29, a partially closed, partially open receptacle 15 is again present for a tube 14, on which an active cooling can take place with a water cooler 16 or cooling by a heat pipe 17.

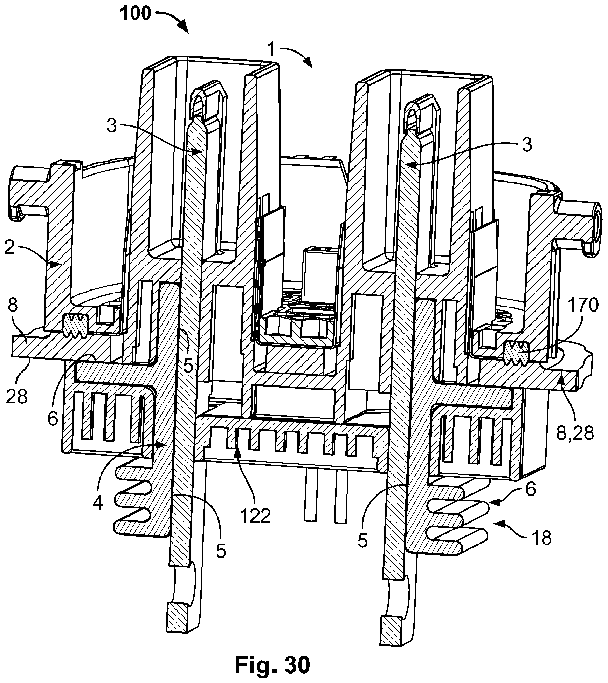

Fig. 30 shows a thirteenth embodiment in which cooling fins 18 are again present which supply an additional heat transfer surface 6 for air-cooling.

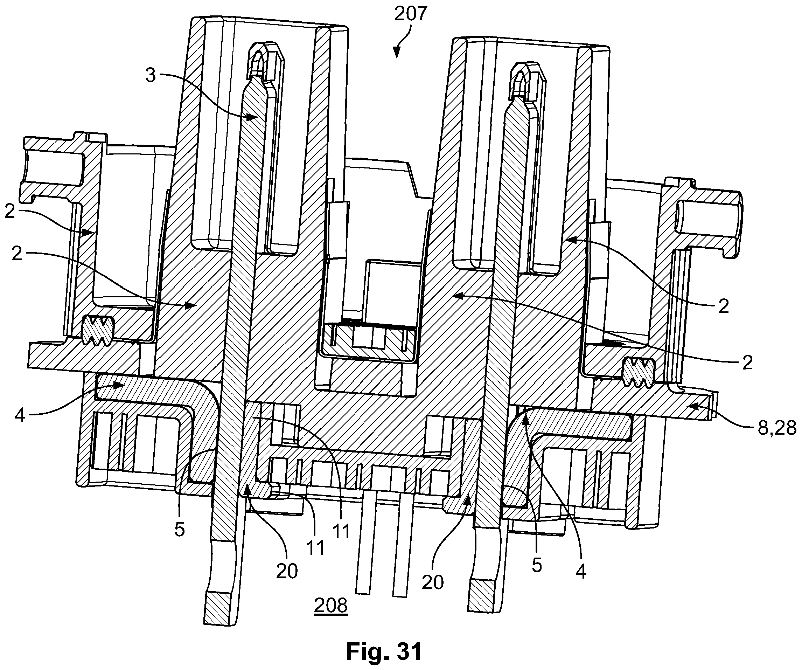

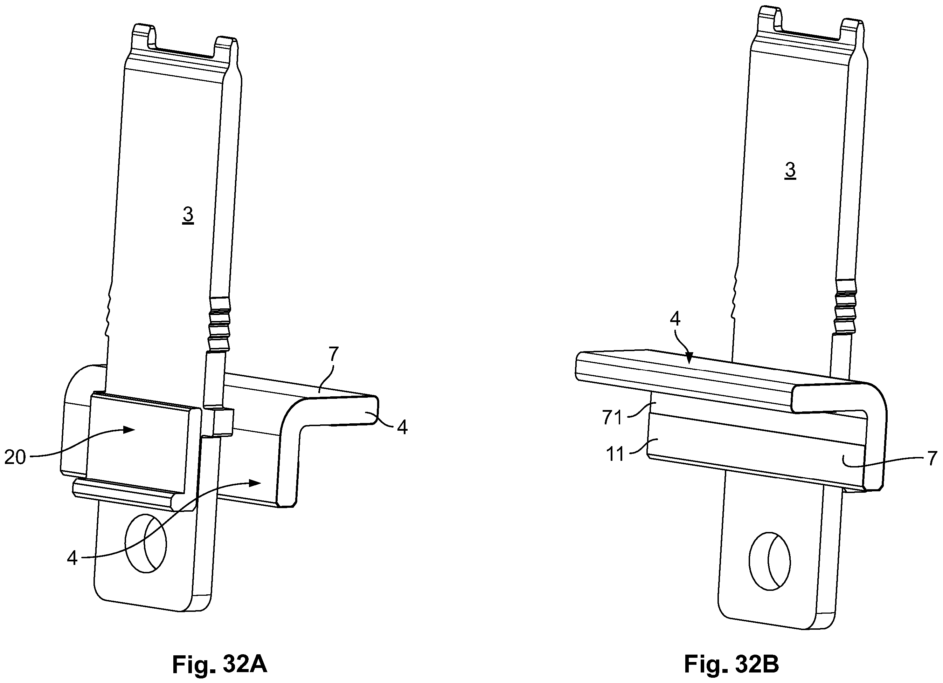

In the embodiment according to Figures 31, 32A and 32B a pressing element 20 is again present which generates a good thermal contact between the contact element 3 and the heat bridge 4. In contrast to the one-part configuration, the pressing element 20 is here inserted into the connector 1 from an underside 208, the underside 208 being located opposite the plug-in side 207. For easier removal, the pressing element 20 also has an L-shape, with it abutting the contact element 3 with one limb and being able to be levered out at the other limb 11 by introducing a screwdriver.

A further difference to the embodiment according to Figs. 18, 19A and 19B is that the pressing element 20 abuts against the contact element 3, as a result of which damage to the heat bridge 4 and in particular to an electrically insulating layer 7 is prevented.

The connector 1 in each case penetrates the unit housing surface 29 in both the one-part and in the two-part embodiments shown, such that complex feedthroughs in the region of the unit housing surface 29 can be dispensed with.

The depicted embodiments each show only planar contact elements 3 with a rectangular cross-section. In a corresponding configuration of the heat absorption surface 5, other cross-section shapes are also possible, for example square or round cross-sections. In the case of a round cross-section, the heat absorption surface can be configured correspondingly complementarily in order to achieve a good heat transfer. A configuration in which the contact element only has a planar side at the location at which the receiving surface is applied, and otherwise has a round cross-section, is also possible.

The heat bridge can also have various configurations. Alternatively to the shown embodiment with a rectangular cross-section, it can have, for example, a cross-section which is triangular, square or differently shaped. Furthermore, a 3D contour can also be present.

### List of reference numbers

- 1: Electrical connector
- 2: Housing
- 3: Electrical contact element
- 4: Heat bridge
- 5: Heat absorption surface
- 6: Heat transfer surface
- 7: Electrically insulating layer
- 8: Heat sink
- 9: Welding connection
- 10: L-shape
- 11: Limb
- 12: Part of an extruded profile
- 13: Inner surface
- 14: Tube
- 15: Receptacle
- 15A: Cylindrical receptacle
- 16: Water cooler
- 17: Heat pipe
- 18: Cooling fins
- 19: Abrasion protection
- 20: Pressing element
- 21: Wedge-shaped pressing element
- 24: Housing part
- 25: Holding element
- 26: Base
- 28: Unit housing
- 29: Unit housing surface
- 30: Recess
- 31: Heat contact tongue
- 36: Additional heat transfer surface
- 71: Foil
- 100: Electrical connection arrangement
- 103: Point of connection
- 104: Heat flow
- 108: Support surface
- 121: First housing part
- 122: Second housing part
- 150: Hole
- 151: Screw
- 152: Mating element
- 160: Terminal element
- 170: Seal
- 180: Shielding
- 190: Step
- 203: Longitudinal direction
- 205: Receptacle
- 207: Plug-in side
- 208: Underside

## Claims

1. An electrical connector (1), comprising a housing (2), an electrical contact element (3) which is received in the housing (2), and a heat bridge (4) which has a heat absorption surface (5) which is thermally connected to the electrical contact element (3), and a heat transfer surface (6) which is accessible from outside the connector (1) and which is electrically insulated from the contact element (3), wherein the heat absorption surface (5) and the heat transfer surface (6) are arranged L-shaped with respect to one another in a cross-section of the heat bridge (4), **characterized in that** the heat bridge (4) is connected to the electrical contact element (3) via a welding connection (9), wherein the heat bridge (4) has an electrically insulating layer (7) on the heat absorption surface (5) and/or on the heat transfer surface (6), and wherein an abrasion protection (19) is arranged between the electrically insulating layer (7) and the housing (2).

2. The electrical connector (1) according to Claim 1, wherein the heat bridge (4) comprises a separated part (12) of an extruded profile.

3. The electrical connector (1) according to any one of Claims 1 or 2, wherein the heat transfer surface (6) is an inner surface (13) of a pipe (14).

4. The electrical connector (1) according to any one of Claims 1 to 3, wherein the heat bridge (4) has at least one additional heat transfer surface (6, 36).

5. The electrical connector (1) according to any one of Claims 1 to 4, wherein the electrical connector (1) has a pressing element (20) via which, in an assembled state, a contact pressure is produced between the electrical contact element (3), the heat bridge (4) and/or the housing (2).

6. An electrical connection arrangement (100), comprising an electrical connector (1) according to any one of Claims 1 to 5 and a heat sink (8) attached thereto.

7. The electrical connection arrangement (100) according to Claim 6, wherein the heat bridge (4) is connected to the heat sink (8) in an electrically insulating manner.

8. The electrical connection arrangement (100) according to Claim 6 or 7, wherein the electrical connection arrangement (100) has a unit housing (28), in particular of a vehicle unit, which serves as a heat sink (8).

9. The electrical connection arrangement (100) according to Claim 8, wherein the electrical connector (1) penetrates a unit housing surface (29).

10. The electrical connection according to any one of Claims 8 or 9, wherein the unit housing (28) has a heat contact tongue (30) which projects into a recess (30) for the connector (1) and which is in direct thermal contact with the heat bridge (4).

11. The electrical connection arrangement (100) according to Claim 10, wherein the contact tongue (30) projects into the recess (30) perpendicular to a longitudinal direction (203) of the electrical contact element (3).

## Patentansprüche

1. Elektrischer Verbinder (1), der ein Gehäuse (2), ein elektrisches Kontaktelement (3), das in dem Gehäuse (2) aufgenommen ist, und eine Wärmebrücke (4) umfasst, die eine Wärmeabsorptions-Fläche (5), die mit dem elektrischen Kontaktelement (3) thermisch verbunden ist, sowie eine Wärmeübertragungs-Fläche (6) aufweist, die von außerhalb des Verbinders (1) zugänglich ist und die gegenüber dem Kontaktelement (3) elektrisch isoliert ist, wobei die Wärmeabsorptions-Fläche (5) und die Wärmeübertragungs-Fläche (6) in einem Querschnitt der Wärmebrücke (4) L-förmig zueinander angeordnet sind, **dadurch gekennzeichnet, dass**
die Wärmebrücke (4) über eine Schweißverbindung (9) mit dem elektrischen Kontaktelement (3) verbunden ist, wobei die Wärmebrücke (4) eine elektrisch isolierende Schicht (7) auf der Wärmeabsorptions-Fläche (5) und/oder auf der Wärmeübertragungs-Fläche (6) aufweist, und zwischen der elektrisch isolierenden Schicht (7) und dem Gehäuse (2) ein Abriebschutz (19) angeordnet ist.

2. Elektrischer Verbinder (1) nach Anspruch 1, wobei die Wärmebrücke (4) einen abgetrennten Teil (12) eines Strangpressprofils umfasst.

3. Elektrischer Verbinder (1) nach einem der Ansprüche 1 oder 2, wobei die Wärmeübertragungs-Fläche (6) eine Innenfläche (13) eines Rohrs (14) ist.

4. Elektrischer-Verbinder (1) nach einem der Ansprüche 1 bis 3, wobei die Wärmebrücke (4) wenigstens eine zusätzliche Wärmeübertragungs-Fläche (6, 36) aufweist.

5. Elektrischer Verbinder (1) nach einem der Ansprüche 1 bis 4, wobei der elektrische Verbinder (1) ein Press-Element (20) aufweist, über das in einem montierten Zustand ein Kontaktdruck zwischen dem elektrischen Kontaktelement (3), der Wärmebrücke (4) und/oder dem Gehäuse (2) erzeugt wird.

6. Elektrische Verbindungsanordnung (100), die einen elektrischen Verbinder (1) nach einem der Ansprüche 1 bis 5 sowie einen daran angebrachten Kühlkörper (8) umfasst.

7. Elektrische Verbindungsanordnung (100) nach Anspruch 6, wobei die Wärmebrücke (4) mit dem Kühlkörper (8) elektrisch isolierend verbunden ist.

8. Elektrische Verbindungsanordnung (100) nach Anspruch 6 oder 7, wobei die elektrische Verbindungsanordnung (100) ein als ein Kühlkörper (8) dienendes Gehäuse (28) einer Einheit, insbesondere einer Fahrzeug-Einheit, aufweist.

9. Elektrische Verbindungsanordnung (100) nach Anspruch 8, wobei sich der elektrische Verbinder (1) durch eine Fläche (29) des Gehäuses der Einheit hindurch erstreckt.

10. Elektrische Verbindung nach einem der Ansprüche 8 oder 9, wobei das Gehäuse (28) einer Einheit eine Wärme-Kontaktzunge (30) aufweist, die in eine Aussparung (30) für den Verbinder (1) hinein vorsteht und die in direktem thermischem Kontakt mit der Wärmebrücke (4) ist.

11. Elektrische Verbindungsanordnung (100) nach Anspruch 10, wobei die Kontaktzunge (30) senkrecht zu einer Längsrichtung (203) des elektrischen Kontaktelementes (3) in die Aussparung (30) hinein vorsteht.

## Revendications

1. Connecteur électrique (1), comprenant un boîtier (2), un élément de contact électrique (3) qui est accueilli dans le boîtier (2), et un pont thermique (4) qui présente une surface d'absorption de chaleur (5) qui est thermiquement connectée à l'élément de contact électrique (3), et une surface de transfert thermique (6) qui est accessible depuis un extérieur du connecteur (1) et qui est électriquement isolée de l'élément de contact (3), dans lequel la surface d'absorption de chaleur (5) et la surface de transfert thermique (6) sont disposées en L l'une par rapport à l'autre dans une coupe transversale du pont thermique (4), **caractérisé en ce que** le pont thermique (4) est connecté à l'élément de contact électrique (3) via une connexion par soudure (9), dans lequel le pont thermique (4) présente une couche électriquement isolante (7) sur la surface d'absorption de chaleur (5) et/ou sur la surface de transfert thermique (6), et dans lequel une protection contre l'abrasion (19) est disposée entre la couche électriquement isolante (7) et le boîtier (2).

2. Le connecteur électrique (1) selon la revendication 1, dans lequel le pont thermique (4) comprend une partie séparée (12) d'un profil extrudé.

3. Le connecteur électrique (1) selon l'une quelconque de la revendication 1 ou 2, dans lequel la surface de transfert thermique (6) est une surface intérieure (13) d'un conduit (14).

4. Le connecteur électrique (1) selon l'une quelconque des revendications 1 à 3, dans lequel le pont thermique (4) présente au moins une surface de transfert thermique supplémentaire (6, 36).

5. Le connecteur électrique (1) selon l'une quelconque des revendications 1 à 4, dans lequel le connecteur électrique (1) présente un élément de pression (20) via lequel, dans un état assemblé, une pression de contact est produite entre l'élément de contact électrique (3), le pont thermique (4) et/ou le boîtier (2).

6. Disposition de connexion électrique (100), comprenant un connecteur électrique (1) selon l'une quelconque des revendications 1 à 5 et un dissipateur thermique (8) rattaché à celui-ci.

7. La disposition de connexion électrique (100) selon la revendication 6, dans laquelle le pont thermique (4) est connecté au dissipateur thermique (8) de manière électriquement isolée.

8. La disposition de connexion électrique (100) selon la revendication 6 ou 7, dans laquelle la disposition de connexion électrique (100) présente un boîtier d'unité (28), en particulier d'une unité de véhicule, qui sert de dissipateur thermique (8).

9. La disposition de connexion électrique (100) selon la revendication 8, dans laquelle le connecteur électrique (1) pénètre une surface de boîtier d'unité (29).

10. La disposition de connexion électrique (100) selon l'une quelconque de la revendication 8 ou 9, dans laquelle le boîtier d'unité (28) présente une languette de contact thermique (30) qui se projette dans une cavité (30) pour le connecteur (1) et qui est en contact thermique direct avec le pont thermique (4).

11. La disposition de connexion électrique (100) selon la revendication 10, dans laquelle la languette de contact (30) se projette dans la cavité (30) perpendiculaire à une direction longitudinale (203) de l'élément de contact électrique (3).
